# FASCICULE DE BREVET EUROPEEN

(11) **EP 1 560 032 B1**
(45) Date de publication et mention de la délivrance du brevet: **30.08.2006**
(21) Numéro de dépôt: 05290173.3
(22) Date de dépôt: 26.01.2005
(51) Int. Cl.: G01R 31/3185, G06F 12/00

(54) **Procédé de sécurisation du mode de test d'un circuit intégré par détection d'intrusion**
Verfahren zur Absicherung des Testmodus einer integrierten Schaltung mittels Eindringungserkennung
Integrated circuit test mode securisation method by intrusion detection

(30) Priorité: 29.01.2004 FR 0400837
(43) Date de publication de la demande: 03.08.2005
(73) Titulaire: STMicroelectronics S.A., 92120 Montrouge (FR)
(72) Inventeur: Bancel, Frédéric, 13113 Lamanon (FR); Hely, David, 13170 Les Pennes Mirabeau (FR)
(74) Mandataire: Bentz, Jean-Paul

(56) Documents cités:
- EP-A- 1 089 083
- US-A1- 2003 204 801
- US-A1- 2003 218 475
- US-B1- 6 496 119
- PATENT ABSTRACTS OF JAPAN vol. 2003, no. 01, 14 janvier 2003 (2003-01-14) -& JP 2002 269523 A (MATSUSHITA ELECTRIC IND CO LTD), 20 septembre 2002 (2002-09-20)
- JARAMILLO K ET AL: "10 TIPS FOR SUCCESSFUL SCAN DESIGN: PART ONE" EDN ELECTRICAL DESIGN NEWS, CAHNERS PUBLISHING CO. NEWTON, MASSACHUSETTS, US, vol. 45, no. 4, 17 février 2000 (2000-02-17), pages 67-73,75, XP000966353 ISSN: 0012-7515

## Description

L'invention concerne, de façon générale, les circuits électroniques intégrés synchrones munis de moyens de logique combinatoire, de bascules, et de moyens de test.

Plus précisément, l'invention concerne un circuit électronique comprenant : une pluralité de cellules logiques; une pluralité de cellules configurables comprenant chacune au moins un multiplexeur et une bascule; et une pluralité de conducteurs de commande reliés, pour partie d'entre eux au moins, aux cellules configurables et sur lesquels circulent sélectivement des signaux de commande reçus et / ou émis en fonctionnement par un circuit de commande tel qu'un contrôleur d'accès, les cellules configurables adoptant sélectivement, en fonction des signaux de commande, un mode de fonctionnement standard dans lequel elles sont fonctionnellement reliées à certaines au moins des cellules logiques avec lesquelles elles coopèrent pour former un circuit logique, et un mode de test dans lequel ces cellules configurables sont fonctionnellement connectées en chaîne pour former un registre à décalage doté d'une entrée et d'une sortie de données.

Il est aujourd'hui bien connu de vérifier le fonctionnement correct des éléments fonctionnels d'un circuit intégré en imposant et / ou en déterminant, à des instants prédéfinis, des valeurs de données présentes en certains points internes de ce circuit intégré.

Une telle technique de test des chemins internes d'un circuit intégré (désignée par "scanpath" ou "internal scan method" en langue anglaise) est par exemple décrite dans la publication de M. Williams et J. Angel, intitulée "Enhancing Testability of LSI Circuits Via Test Points and Additional Logic, IEEE Transactions on Computers, vol. C-22, no.1; Janvier 1973".

Selon cette technique, chacune des bascules du circuit logique, dont il est utile de connaître l'état et / ou d'imposer le contenu durant le fonctionnement standard du circuit intégré, est dotée à son entrée d'un multiplexeur.

Les différentes bascules et les multiplexeurs qui leur sont associés constituent ainsi autant de cellules configurables dont les accès sont contrôlés par ces multiplexeurs.

Les multiplexeurs de ces différentes cellules configurables sont collectivement commandés par un contrôleur d'accès ou "contrôleur TAP" ("TAP" pour "Test Access Port" en langue anglaise) qui, en fonction d'un mode de fonctionnement choisi, utilise cet ensemble de cellules configurables soit comme un circuit fonctionnel standard, intégré au circuit logique qu'il forme avec les cellules logiques, soit comme un circuit de test.

Pour ce faire, le contrôleur TAP reçoit sur différents conducteurs de commande, et / ou adresse sur différents conducteurs de commande par lesquels il est relié aux différentes cellules configurables, des signaux de commande, tels qu'un signal de commande de mode, un signal de commande de chaînage ou encore un signal de commande de propagation de données, qui autorisent à modifier et / ou modifient les chemins de circulation des données au sein du circuit intégré et qui permettent ainsi la capture de ces données par le contrôleur, en vue de leur analyse ultérieure.

En mode de fonctionnement standard, le contrôleur TAP pilote donc les multiplexeurs des cellules configurables de manière que les bascules de ces cellules soient connectées à des cellules logiques environnantes pour définir un ou plusieurs sous-ensembles fonctionnels du circuit intégré.

Dans le mode de test, qui est normalement déclenché à réception par le contrôleur TAP d'un signal de commande de passage en mode de test, ce contrôleur produit un signal de commande de chaînage pour connecter en série les bascules des cellules configurables de manière à former un registre à décalage.

Ce registre comporte notamment une entrée série et une sortie série respectivement connectées à une sortie et à une entrée du contrôleur TAP, ainsi qu'une entrée d'horloge recevant un.signal d'horloge pour cadencer le flot de données.

Dans un premier temps, le contrôleur TAP charge en série des données dans les bascules des cellules configurables par l'entrée du registre à décalage que forment ces cellules.

Puis, le contrôleur TAP change la commutation des multiplexeurs pour former le circuit fonctionnel, et commande l'exécution d'un ou plusieurs cycles d'horloge par ce circuit fonctionnel. Dans cette phase, les données chargées dans les bascules des cellules configurables sont traitées par le circuit fonctionnel.

Le contrôleur change alors une nouvelle fois la commutation des multiplexeurs pour former à nouveau le registre à décalage et récupère, en série sur la sortie de ce registre à décalage, les données mémorisées dans les bascules des cellules configurables durant le dernier cycle d'horloge.

En dépit de l'intérêt confirmé de cette technique de test, son application pratique peut en certaines circonstances s'avérer problématique, notamment sur les circuits intégrés qui traitent des données secrètes.

En effet, dans la mesure où l'activation du mode de test peut permettre à un fraudeur de lire le contenu des bascules des cellules configurables, cette technique de test présente a priori l'inconvénient de rendre de tels circuits très vulnérables à une utilisation frauduleuse.

Par exemple, en stoppant à divers moments un processus de chargement interne de données secrètes dans le circuit intégré et en déchargeant le contenu du registre à décalage, un fraudeur pourra obtenir des informations sur des données secrètes, voire les reconstituer.

En activant le mode de test, un fraudeur pourra également accéder en écriture aux bascules des cellules configurables pour insérer des données frauduleuses, ou bien pour placer le circuit intégré dans une configuration non autorisée. Il pourra ainsi par exemple accéder à un registre contrôlant un organe sécuritaire tel qu'un capteur pour le désactiver. Il pourra également injecter une donnée erronée en vue d'obtenir de l'information sur une donnée secrète.

La fraude peut en fait adopter deux stratégies différentes, dont la première consiste à prendre le contrôle du contrôleur TAP et à observer sur les plots externes le contenu des cellules du registre à décalage, et dont la seconde consiste à prendre le contrôle des cellules configurables en les excitant par micro-sondage de manière à simuler le pilotage de ces cellules par les signaux de commande qu'émet le contrôleur TAP.

Une tentative de fraude conforme à la première stratégie peut être bloquée par une technique qui fait l'objet d'une demande de brevet déposée parallèlement par le Titulaire.

En revanche, le but de la présente invention est précisément de proposer un circuit électronique conçu pour faire échec à une tentative de fraude conforme à la seconde stratégie évoquée ci-dessus.

A cette fin, le circuit électronique de l'invention, par ailleurs conforme à la définition générique qu'en donne le préambule ci-dessus, est essentiellement caractérisé en ce qu'il comprend un circuit d'espionnage relié aux conducteurs de commande, opérant une combinaison logique des signaux transitant sur ces conducteurs de commande, et délivrant un signal de sortie adoptant sélectivement un état représentatif d'une absence d'anomalie ou un état représentatif d'une tentative d'intrusion, selon que la combinaison des signaux transitant sur les conducteurs de commande correspond, ou non, à une combinaison de signaux de commande observable dans un état de fonctionnement autorisé du circuit électronique.

Par exemple, il est possible de prévoir que le circuit d'espionnage opère une combinaison de signaux circulant sur un premier ensemble de plusieurs conducteurs de commande dont chacun est assigné à la transmission du signal de commande de chaînage configurant les cellules configurables en registre à décalage, et que le circuit d'espionnage délivre au moins un signal de sortie de premier type adoptant un état représentatif d'une absence d'anomalie si et seulement si les signaux circulant sur le premier ensemble de conducteurs de commande sont simultanément dans le même état.

Il est cependant aussi possible, à la place ou en complément de la mesure précédente, de prévoir que le circuit d'espionnage opère une combinaison de signaux circulant sur un second ensemble de plusieurs conducteurs de commande dont un premier au moins est assigné à la transmission du signal de commande de chaînage, dont un second au moins est assigné à la transmission du signal de commande de passage en mode de test qui active le circuit de commande, et dont un troisième au moins est assigné à la transmission du signal de commande de propagation de données dans les cellules configurables, et que le circuit d'espionnage délivre au moins un signal de sortie de second type adoptant un état représentatif d'une tentative d'intrusion si l'un ou l'autre des signaux de commande de passage en mode de test et de commande de propagation est inactif, alors que le signal de commande de chaînage est actif.

Quel que soit le mode de réalisation particulier choisi, il est avantageux de prévoir que le signal de sortie du circuit d'espionnage soit acheminé aux cellules configurables et remette à zéro les bascules de ces cellules configurables lorsqu'il adopte son état représentatif d'une tentative d'intrusion.

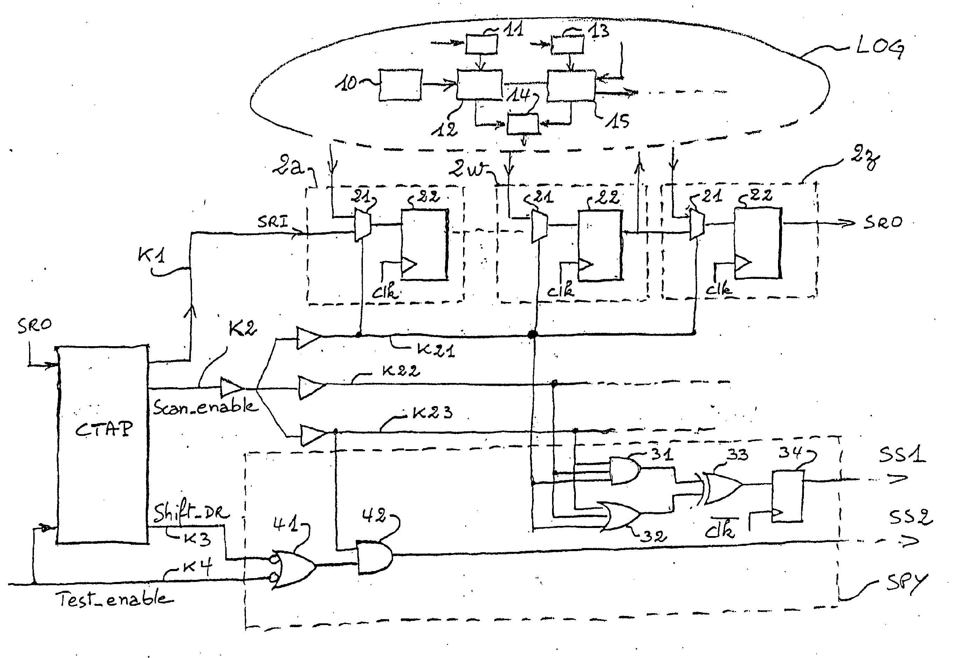

D'autres caractéristiques et avantages de l'invention ressortiront clairement de la description qui en est faite ci-après, à titre indicatif et nullement limitatif, en référence à l'unique figure annexée, qui est un schéma illustrant un circuit électronique conforme à deux modes de réalisation de l'invention, utilisables aussi bien séparément que cumulativement, et représentés simultanément.

Comme annoncé précédemment, l'invention concerne un circuit électronique doté de moyens de test internes.

Un tel circuit comprend typiquement une pluralité de cellules logiques telles que les cellules 10 à 15, une pluralité de cellules configurables telles que les cellules 2a, 2w, et 2z, une pluralité de conducteurs de commande tels que les conducteurs K1 à K4 et K21 à K23, ainsi éventuellement qu'un circuit de commande tel qu'un contrôleur d'accès CTAP, qui peut aussi, toutefois, être externe au circuit électronique considéré.

Chacune des cellules configurables telles que 2a, 2w, et 2z comprend au moins un multiplexeur 21 et au moins une bascule 22.

Les conducteurs de commande K1 à K4 et K21 à K23, dont certains au moins sont reliés aux cellules configurables 2a, 2w, et 2z, servent à la transmission de signaux de commande sélectivement reçus et / ou émis en fonctionnement par le circuit de commande CTAP, tels qu'un signal de commande de passage en mode de test Test_enable qui active le circuit de commande CTAP, un signal de commande de chaînage Scan_enable qui chaîne les cellules configurables sous forme d'un registre à décalage, et un signal de commande Shift_DR qui permet la propagation de données dans les cellules configurables.

En fonction de ces signaux de commande ou de certains au moins d'entre eux, les cellules configurables 2a, 2w, et 2z adoptent soit un mode de fonctionnement standard, dans lequel elles sont fonctionnellement reliées à certaines au moins des cellules logiques 10 à 15 avec lesquelles elles coopèrent pour former un circuit logique LOG, soit un mode de test dans lequel ces cellules configurables 2a, 2w, 2z sont fonctionnellement connectées l'une à l'autre en chaîne pour former un registre à décalage.

Le passage des cellules configurables du mode de fonctionnement standard au mode de test est effectué par le pilotage des multiplexeurs 21 au moyen de certains au moins des signaux de commande délivrés par le circuit de commande CTAP.

Le registre à décalage 2a à 2z présente notamment une entrée de données SRI pilotée par une sortie du circuit de commande CTAP, une sortie de données SRO, reliée à une entrée du circuit de commande CTAP, et une entrée d'horloge (non spécifiquement représentée) pour recevoir un signal d'horloge Clk propre à cadencer le flot de données dans ce registre à décalage.

Pour lancer un test, un signal Test_enable de commande de passage en mode de test doit d'abord être adressé au circuit de commande CTAP sur le conducteur de commande K4.

Le circuit de commande CTAP configure alors les cellules configurables 2a à 2z en registre à décalage par l'émission du signal de commande de chaînage Scan_enable.

Puis, par émission du signal de commande de propagation Shift_DR, le circuit de commande CTAP charge en série des données de test dans les bascules 22 de ces cellules configurables à travers l'entrée SRI du registre à décalage.

Puis, par désactivation du signal de commande de chaînage Scan_enable, le circuit de commande CTAP reconfigure les cellules configurables 2a à 2z en élément fonctionnel du circuit logique LOG et commande l'exécution d'un ou plusieurs cycles d'horloge par cet élément fonctionnel, qui traite les données de test.

Par réactivation du signal de commande de chaînage Scan_enable, le circuit de commande CTAP reconfigure à nouveau les cellules configurables 2a à 2z en registre à décalage.

Enfin, par émission du signal de commande de propagation Shift_DR, le circuit de commande CTAP récupère, à la sortie SRO de ce registre, les données mémorisées dans les bascules 22 et issues du traitement des données de test par le circuit logique LOG.

Pour éviter notamment qu'un fraudeur ne puisse simuler une telle procédure de test en appliquant directement des signaux de commande sur les conducteurs K1 à K4 et K21 à K23, et / ou des données sur l'entrée SRI, et ne puisse récupérer ainsi frauduleusement les données mémorisées dans les bascules 22 et issues du traitement des données de test par le circuit logique LOG, le circuit électronique de l'invention comprend un circuit d'espionnage SPY relié aux conducteurs de commande tels que K1 à K4 et K21 à K23.

Ce circuit d'espionnage SPY, qui opère une combinaison logique des signaux transitant sur différents conducteurs de commande, a pour fonction de délivrer un signal de sortie tel que SS1 ou SS2 dont l'état est représentatif d'une absence d'anomalie ou au contraire d'une tentative d'intrusion.

Plus précisément, le signal de sortie SS1 ou SS2 du circuit d'espionnage SPY adopte un état représentatif d'une absence d'anomalie ou d'une tentative d'intrusion selon que la combinaison des signaux transitant sur les conducteurs de commande espionnés correspond, ou non, à une combinaison de signaux de commande observable dans un état de fonctionnement autorisé du circuit électronique.

Par exemple, dans l'un des modes de réalisation illustrés, le circuit d'espionnage SPY opère une combinaison de signaux circulant sur un premier ensemble de conducteurs de commande K21 à K23 dont chacun est assigné à la transmission du signal de commande de chaînage Scan_enable, qui configure les cellules configurables en registre à décalage.

Ce circuit d'espionnage SPY comporte des portes logiques ET 31, OU 32, OU EXCLUSIF 33 et une bascule 34 interconnectées comme illustré et délivre ainsi un signal de sortie SS1 qui adopte un état représentatif d'une absence d'anomalie si et seulement si les signaux circulant sur les conducteurs de commande K21 à K23 sont simultanément dans le même état.

Le circuit d'espionnage SPY est ainsi en mesure de détecter si l'un ou l'autre des conducteurs de commande K21 à K23, sur lesquels transite normalement le même signal, a fait l'objet d'une attaque visant à le forcer à une autre valeur.

Dans le second mode de réalisation illustré, et cumulable avec le premier, le circuit d'espionnage SPY opère une combinaison de signaux circulant sur un second ensemble de conducteurs de commande K23, K3, et K4 dont le premier, K23, est assigné à la transmission du signal de commande de chaînage Scan_enable configurant les cellules configurables en registre à décalage, dont le second K4 est assigné à la transmission du signal de commande de passage en mode de test Test_enable qui active le circuit de commande, et dont le troisième K3 est assigné à la transmission du signal Shift_DR de commande de propagation de données dans les cellules configurables.

Ce circuit d'espionnage SPY comporte des portes logiques NON-OU 41 et ET 42 interconnectées comme illustré et délivre ainsi un signal de sortie SS2 qui adopte un état représentatif d'une tentative d'intrusion si l'un ou l'autre des signaux de commande de passage en mode de test Test_enable et de commande de propagation Shift_DR est inactif, alors que le signal de commande de chaînage Scan_enable est actif.

Le circuit d'espionnage SPY exploite ainsi la cohérence existant normalement entre les états que prennent au cours du temps les différents signaux de commande internes du circuit électronique pour avertir, en cas de détection d'une rupture de cette cohérence, que l'un des conducteurs de commande sur lequel transite normalement un signal de commande astreint à cette cohérence a fait l'objet d'une attaque visant à le forcer à une valeur différente de celle que prévoit cette même cohérence.

Dans tous les cas, le signal de sortie SS1 et / ou SS2 du circuit d'espionnage SPY est avantageusement acheminé aux cellules configurables 2a, 2w, et 2z et remet à zéro les bascules 22 de ces cellules configurables lorsqu'il adopte son état représentatif d'une tentative d'intrusion.

## Revendications

1. Circuit électronique, comprenant : une pluralité de cellules logiques (10-15); une pluralité de cellules configurables (2a, 2w, 2z) comprenant chacune au moins un multiplexeur (21) et une bascule (22); et une pluralité de conducteurs de commande (K1-K4, K21-K23) reliés, pour partie d'entre eux au moins, aux cellules configurables (2a, 2w, 2z) et sur lesquels circulent sélectivement des signaux de commande (Test_enable, Scan_enable, Shift_DR) reçus et / ou émis en fonctionnement par un circuit de commande (CTAP) tel qu'un contrôleur d'accès, les cellules configurables (2a, 2w, 2z) adoptant sélectivement, en fonction des signaux de commande, un mode de fonctionnement standard dans lequel elles sont fonctionnellement reliées à certaines au moins des cellules logiques (10-15) avec lesquelles elles coopèrent pour former un circuit logique (LOG), et un mode de test dans lequel ces cellules configurables (2a, 2w, 2z) sont fonctionnellement connectées en chaîne pour former un registre à décalage doté d'une entrée (SRI) et d'une sortie (SRO) de données, **caractérisé en ce qu'**il comprend en outre un circuit d'espionnage (SPY) relié aux conducteurs de commande (K1-K4, K21-K23), opérant une combinaison logique des signaux transitant sur ces conducteurs de commande, et délivrant un signal de sortie (SS1, SS2) adoptant sélectivement un état représentatif d'une absence d'anomalie ou un état représentatif d'une tentative d'intrusion, selon que la combinaison des signaux transitant sur les conducteurs de commande (K1-K4, K21-K23) correspond, ou non, à une combinaison de signaux de commande observable dans un état de fonctionnement autorisé du circuit électronique.

2. Circuit électronique suivant la revendication 1, **caractérisé en ce que** le circuit d'espionnage (SPY) opère une combinaison de signaux circulant sur un premier ensemble de plusieurs conducteurs de commande (K21-K23) dont chacun est assigné à la transmission du signal de commande de chaînage (Scan_enable) configurant les cellules configurables en registre à décalage, et **en ce que** le circuit d'espionnage (SPY) délivre au moins un signal de sortie de premier type (SS1) adoptant un état représentatif d'une absence d'anomalie si et seulement si les signaux circulant sur le premier ensemble de conducteurs de commande sont simultanément dans le même état.

3. Circuit électronique suivant la revendication 1 ou 2, **caractérisé en ce que** le circuit d'espionnage (SPY) opère une combinaison de signaux circulant sur un second ensemble de plusieurs conducteurs de commande (K23, K3, K4) dont un premier au moins (K23) est assigné à la transmission du signal de commande de chaînage (Scan_enable) configurant les cellules configurables en registre à décalage, dont un second au moins (K4) est assigné à la transmission du signal de commande de passage en mode de test (Test _enable) qui active le circuit de commande, et dont un troisième au moins (K3) est assigné à la transmission du signal (Shift_DR) de commande de propagation de données dans les cellules configurables, et **en ce que** le circuit d'espionnage (SPY) délivre au moins un signal de sortie de second type (SS2) adoptant un état représentatif d'une tentative d'intrusion si l'un ou l'autre des signaux (Test_enable, Shift_DR) de commande de passage en mode de test et de commande de propagation est inactif, alors que le signal de commande de chaînage (Scan_enable) est actif.

4. Circuit électronique suivant l'une quelconque des revendications précédentes, **caractérisé en ce que** le signal de sortie (SS1, SS2) du circuit d'espionnage (SPY) est acheminé aux cellules configurables (2a, 2w, 2z) et remet à zéro les bascules (22) de ces cellules configurables lorsqu'il adopte son état représentatif d'une tentative d'intrusion.

## Claims

1. Electronic circuit comprising: a number of logic cells (10-15); a number of configurable cells (2a, 2w, 2z) each comprising at least a multiplexer (21) and a flip-flop (22) ; and a number of control conductors (K1-K4, K21-K23) connected, for some of them at least, to the configurable cells (2a, 2w, 2z) and on which control signals (Test-enable, Scan-enable and Shift-DR) selectively circulate, received and/or emitted during operation of a control circuit (CTAP) such as an access control, the configurable cells (2a, 2w, 2z) selectively adopting, depending on the control signals, a standard operating mode in which they are operationally connected to at least some of the logic cells (10-15) with which they co-operate to create a logic circuit (LOG), and a test mode in which these configurable cells (2a, 2w, 2z) are operationally connected in chains to create a shift register equipped with a data input (SRI) and a data output (SRO), **characterised in that** it further comprises a spy circuit (SPY) connected to the control conductors (K1-K4, K21-K23), running a logic combination of the signals passing through these control conductors, and delivering an output signal (SS1, SS2) selectively adopting a state representative of no faults or a state representative of attempted intrusion, depending on whether the combination of signals passing through the control conductors (K1-K4, K21-K23) corresponds, or not, to a combination of control signals visible in an authorised operating state of the electronic circuit.

2. Electronic circuit according to claim 1,
**characterised in that** the spy circuit (SPY) runs a combination of signals circulating through a first set of control conductors (K21-K23) of which each is assigned to transmitting the chaining control signal (Scan-enable) configuring the configurable cells in shift register, and **in that** the spy circuit (SPY) delivers at least an output signal of a first type (SS1) adopting a state representative of no faults if, and only if, the signals circulating through the first set of control conductors are simultaneously in the same state.

3. Electronic circuit according to claim 1 or 2, **characterised in that** the spy circuit (SPY) runs a combination of signals circulating through a second set of control conductors (K23, K3, K4) of which at least a first one (K23) is assigned to transmitting the chaining control signal (Scan-enable) configuring the configurable cells in shift register, of which at least a second one (K4) is assigned to transmitting the control signal (Test-enable) of passing in test mode which actuates the control circuit, and of which at least a third one (K3) is assigned to transmitting the control signal (Shift-DR) of data propagation in the configurable cells, and **in that** the spy circuit (SPY) delivers at least an output signal of a second type (SS2) adopting a state representative of attempted intrusion if one or another of the control signals (Test-enable, Shift-DR) of passing in test mode and control signals of propagation is inactive, whereas the chaining control signal (Scan-able) is active.

4. Electronic circuit according to any one of the previous claims, **characterised in that** the output signal (SS1, SS2) of the spy circuit (SPY) is guided to the configurable cells (2a, 2w, 2z) and resets the flip-flops (22) of these configurable cells to zero when it adopts its state representative of attempted intrusion.

## Patentansprüche

1. Elektronische Schaltung umfassend: mehrere Logikzellen (10-15); mehrere konfigurierbare Zellen (2a, 2b, 2z) mit jeweils mindestens einem Multiplexer (21) und einem Flipflop (22); und mehrere Steuerleitungen (K1-K4, K21-K23), die zumindest teilweise mit den konfigurierbaren Zellen (2a, 2w, 2z) verbunden sind und an denen Steuersignale (Test_enable, Scan_enable, und Shift_DR) selektiv zirkulieren, die im Betrieb von einem Steuerschaltkreis (CTAP), wie einem Zugangscontroller, empfangen und/oder versendet werden, wobei die konfigurierbaren Zellen (2a, 2w, 2z) in Abhängigkeit der Steuersignale einen Standardbetriebsmodus selektiv annehmen, in dem sie zumindest mit bestimmten Logikzellen (10-15) betriebsmäßig verbunden sind, mit denen sie kooperieren, um einen logischen Schaltkreis (LOG) zu bilden, und einen Testmodus annehmen, in dem die konfigurierbaren Zellen (2a, 2w, 2z) betriebsmäßig funktionell in Reihe geschaltet sind, um ein Schieberegister zu bilden, das mit einem Dateneingang (SRI) und einem Datenausgang (SRO) versehen ist, **dadurch gekennzeichnet, daß** sie zusätzlich einen Spionageschaltkreis (SPY) umfaßt, der mit den Steuerleitungen (K1-K4, K21-K23) verbunden ist, eine logische Kombination über die Steuerleitungen übergeleiteten Signale ausführt und ein Ausgangssignal (SS1, SS2) bereitstellt, das selektiv einen Zustand repräsentativ für die Abwesenheit einer Anomalie oder einen Zustand repräsentativ für eine vorzeitige Unterbrechung annimmt, je nachdem, ob die Kombination der Signale, die über die Steuerleitungen (K1-K4, und K21 bis K23) übertragen werden, einer Kombination von Steuersignalen, die in einem von der elektronischen Schaltung autorisierten Betriebszustand beobachtet werden können, entsprechen oder nicht.

2. Elektronische Schaltung nach Anspruch 1, **dadurch gekennzeichnet, daß** der Spionageschaltkreis (SPY) eine Kombination von Signalen ausführt, die über eine erste Gruppe von mehreren Steuerleitungen (K21-K23) zirkulieren, von denen jede der Übermittlung des Verkettungs-Steuersignals (Scan_enable) zugeordnet ist, das die zu einem Schieberegister konfigurierbaren Zellen konfiguriert, und daß der Spionageschaltkreis (SPY) mindestens ein Ausgangssignals eines ersten Typs (SS1) bereitstellt, das einen Zustand repräsentativ für die Abwesenheit einer Anomalie nur dann annimmt, wenn die an der ersten Gruppe der Steuerleitung zirkulierenden Signale simultan in dem selben Zustand sind.

3. Elektronische Schaltung nach Anspruch 1 oder 2, **dadurch gekennzeichnet, daß** der Spionageschaltkreis (SPY) eine Kombination von Signalen ausführt, die über eine zweite Gruppe von mehreren Steuerleitungen (K23, K3, K4) zirkulieren, von denen zumindest eine erste (K23) der Übermittlung des Verkettungs-Steuersignals (Scan_enable) zugeordnet ist, das die zu einem Schieberegister konfigurierbaren Zellen konfiguriert, von denen zumindest eine zweite (K4) der Übermittlung des Durchlaßsteuersignals im Testmodus (Test_enable) zugeordnet ist, der den Steuerschaltkreis aktiviert, und von denen zumindest eine dritte (K3) der Übermittlung des Steuersignals (shift_DR) für eine Datenübertragung in die konfigurierbaren Zellen zugeordnet ist, und daß der Spionageschaltkreis (SPY) zumindest ein Ausgangssignal des zweiten Typs (SS2) bereitstellt, das einen Zustand repräsentativ für eine vorzeitige Unterbrechung annimmt, wenn das Durchlaßsteuersignal (Test_enable, Shift_DR) im Testmodus oder das Übertragungssteuersignal inaktiv ist, während das Verkettungs-Steuersignal (Scan_enable) aktiv ist.

4. Elektronische Schaltung nach einem der vorangehenden Ansprüche, **dadurch gekennzeichnet, daß** das Ausgangssignal (SS1, SS2) des Spionageschaltkreises (SPY) zu den konfigurierbaren Zellen (2a, 2w, 2z) weitergeleitet wird und die Flipflops (22) der konfigurierbaren Zellen auf Null stellt, wenn es seinen Zustand repräsentativ für eine vorzeitige Unterbrechung annimmt.
